# EUROPEAN PATENT APPLICATION

(11) **EP 4 795 970 A1**
(43) Date of publication of application: **26.08.2026**
(21) Application number: 25168119.3
(22) Date of filing: 02.04.2025
(51) Int. Cl.: A45C 11/00, A45C 13/10, A45F 5/00

(54) **MAGNETIC CLOSURE SYSTEM FOR A CONTAINER WITH ELECTROMAGNETIC SHIELDING**

(30) Priority: 21.02.2025 WO PCT/US2025/016808
(71) Applicant: Yondr, Inc., Los Angeles, CA 90066 (US)
(72) Inventor: ABDELMALEK, Anthony, Los Angeles, 90066 (US)
(74) Representative: Boult Wade Tennant LLP

(57) **Abstract**

The disclosure is directed to a system for blocking electromagnetic signals by using magnets to seal a container opening, effectively forming a Faraday cage around electronic devices. In some embodiments, the system comprises a pouch body, a shielding pocket, and a lock mechanism. The shielding pocket, positioned within the pouch body, is constructed from materials such as metalized fabrics and conductive threads, which attenuate electromagnetic signals. The pocket includes an opening for device insertion, which is secured by magnetic materials positioned on opposing sides, ensuring continuous electrical contact and preventing signal leakage. In some embodiments, the lock mechanism, featuring first and second lock bodies, further secures the opening, enhancing the electromagnetic shielding properties. Various example implementations of the system include configurations such as discrete magnets and/or strips of magnetic material configured to force and/or maintain the shielding material together to substantially prevent the electronic device from transmitting and/or receiving signals.

## Description

### FIELD OF THE DISCLOSURE

The disclosure relates to containers configured to prevent the transmission and reception of electromagnetic signals. Specifically, the disclosure pertains to locking pouches that incorporate shielding materials to form an electrically conductive enclosure, such as a Faraday cage, around electronic devices.

### SUMMARY OF THE DISCLOSURE

The system described herein is directed to a container comprising a container body, a shielding pocket, a lock, a first magnetic material, and a second magnetic material. The shielding pocket is positioned within the container body and is configured to block electromagnetic signals, and includes an opening configured to enable an electronic device to be inserted into its interior. In some embodiments, the first magnetic material is positioned on a first side of the opening, and the second magnetic material is positioned on a second side of the opening, where the magnetic materials are configured to close the opening through magnetic force.

The shielding pocket forms an electrically conductive enclosure, such as a Faraday cage, around the electronic device. In some embodiments, the shielding pocket is constructed from one or more shielding materials configured to attenuate electromagnetic signals. These materials may include metalized fabrics, nickel-copper coated fabrics, conductive nylon or polyester, silver-plated fabric, as well as other conductive materials. The shielding pocket is positioned between a front panel and a back panel, which are coupled together to form the pouch body. In some embodiments, the shielding pocket is not directly coupled to the front or back panel through perforations, preventing any compromise in the shielding pocket's electromagnetic shielding properties.

The magnetic material is positioned along the edges of the shielding pocket and is configured to attract each other, applying force that brings the shielding pocket material into continuous electrical contact. This magnetic material may include magnets, magnetized strips, or ferromagnetic material, as non-limiting examples, depending on the application. The compressive force of the magnetic material ensures that the shielding pocket remains fully enclosed, thereby completing the Faraday cage electrical circuit and preventing electromagnetic leakage through the opening. The combination of magnetic force and material compression enhances the shielding integrity of the pouch, ensuring effective containment of electromagnetic emissions from the enclosed electronic device.

In some embodiments, the lock includes a first lock body and a second lock body, positioned on either side of the opening. The lock is configured to secure the opening at the pouch body upper portion, providing an entry point for inserting the electronic device. The lock bodies may include magnetic material, where at least one lock body includes magnetized material, enhancing the sealing force applied to the shielding pocket. This configuration ensures that the Faraday cage effect is maintained by fully sealing the shielding pocket from electromagnetic signals.

The system also incorporates various elements to enhance its functionality. For instance, in some embodiments, the magnetic material may be distributed as discrete magnets or as an elongated strip of magnetic material, providing continuous compression along the length of the shielding pocket. In some embodiments, the shielding pocket may also include an extension of the shielding material that is folded over, preventing a direct path for electromagnetic signals to escape, providing an additional barrier that disrupts any potential leakage path through the opening of the shielding pocket.

### DESCRIPTIONS OF THE DRAWINGS

Further features and advantages of the disclosure will be apparent from the following description of embodiments as illustrated in the accompanying drawings, in which reference characters refer to the same parts throughout the various views. The drawings are not necessarily to scale, emphasis instead being placed upon illustrating principles of the disclosure:
FIG. 1 illustrates a locking pouch configured to prevent the transmission and reception of electromagnetic signals in accordance with some embodiments of the present disclosure;
FIG. 2 illustrates the structural components of the locking pouch, in accordance with some embodiments of the present disclosure;
FIG. 3 illustrates the shielding pocket with the front panel removed, in accordance with some embodiments of the present disclosure;
FIG. 4 depicts non-limiting example of a pocket coupling, in accordance with some embodiments of the present disclosure;
FIG. 5 illustrates the pocket opening of the shielding pocket, in accordance with some embodiments of the present disclosure;
FIG. 6 illustrates a first strip of magnetic material and a second strip of magnetic material, in accordance with some embodiments of the present disclosure;
FIG. 7 illustrates the magnetic arrangement within the first strip and second strip, in accordance with some embodiments of the present disclosure;
FIG. 8 shows the flexibility and alignment of the first strip and the second strip, in accordance with some embodiments of the present disclosure;
FIG. 9 illustrates example dimensions for the strip and the magnetic materials housed within the strip, in accordance with some embodiments of the present disclosure;
FIG. 10 illustrates a first side and a second side of the locking pouch, in accordance with some embodiments of the present disclosure;
FIG. 11 illustrates a first strip with three sets of magnetic material and a second side incorporating a ferromagnetic plate, in accordance with some embodiments of the present disclosure;
FIG. 12 illustrates a first side containing a magnetized strip and a second side incorporating a ferromagnetic plate, in accordance with some embodiments of the present disclosure;
FIG. 13 illustrates a locking pouch with the shielding pocket extending above the top portion of the locking pouch, in accordance with some embodiments of the present disclosure;
FIG. 14 illustrates a locking pouch where the magnetic material is distributed as four individual magnets embedded within the lock body, in accordance with some embodiments of the present disclosure;
FIG. 15 illustrates a locking pouch where the magnetic material includes an elongated strip of magnetic material instead of discrete magnets, in accordance with some embodiments of the present disclosure; and
FIG. 16 illustrates a locking pouch where the top portion of the shielding pocket includes an extension of the shielding material that is folded over, in accordance with some embodiments of the present disclosure.

### DETAILED DESCRIPTION

The present disclosure will now be described more fully hereinafter with reference to the accompanying drawings, which form a part hereof, and which show, by way of non-limiting illustration, certain example embodiments. Subject matter may, however, be embodied in a variety of different forms and, therefore, covered or claimed subject matter is intended to be construed as not being limited to any example embodiments set forth herein; example embodiments are provided merely to be illustrative. Likewise, a reasonably broad scope for claimed or covered subject matter is intended. Among other things, for example, subject matter may be embodied as methods, devices, components, or systems. The following detailed description is, therefore, not intended to be taken in a limiting sense.

Throughout the specification and claims, terms may have nuanced meanings suggested or implied in context beyond an explicitly stated meaning. Likewise, the phrase "in some embodiments" as used herein does not necessarily refer to the same embodiment and phrases such as "in another embodiment" or "in various embodiments" as used herein does not necessarily refer to a different embodiment. It is intended, for example, that claimed subject matter include combinations of example embodiments shown in the figures, in whole or in part.

In general, terminology may be understood at least in part from usage in context. For example, terms, such as "and", "or", or "and/or," as used herein may include a variety of meanings that may depend at least in part upon the context in which such terms are used. Typically, "or" if used to associate a list, such as A, B or C, is intended to mean A, B, and C, here used in the inclusive sense, as well as A, B or C, here used in the exclusive sense. In addition, the term "one or more" as used herein, depending at least in part upon context, may be used to describe any feature, structure, or characteristic in a singular sense or may be used to describe combinations of features, structures, or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

For purposes of this disclosure, an electronic device (or mobile, user, entity, subscriber or customer) device may include a computing device capable of sending or receiving signals, such as via a wired or a wireless network. A client device may, for example, include a portable device, such as a cellular telephone, a smartphone, a display pager, a radio frequency (RF) device, an infrared (IR) device a Near Field Communication (NFC) device, a Personal Digital Assistant (PDA), a handheld computer, a tablet computer, a phablet, a laptop computer, a set top box, a wearable computer, smart watch, an integrated or distributed device combining various features, such as features of the foregoing devices, or the like.

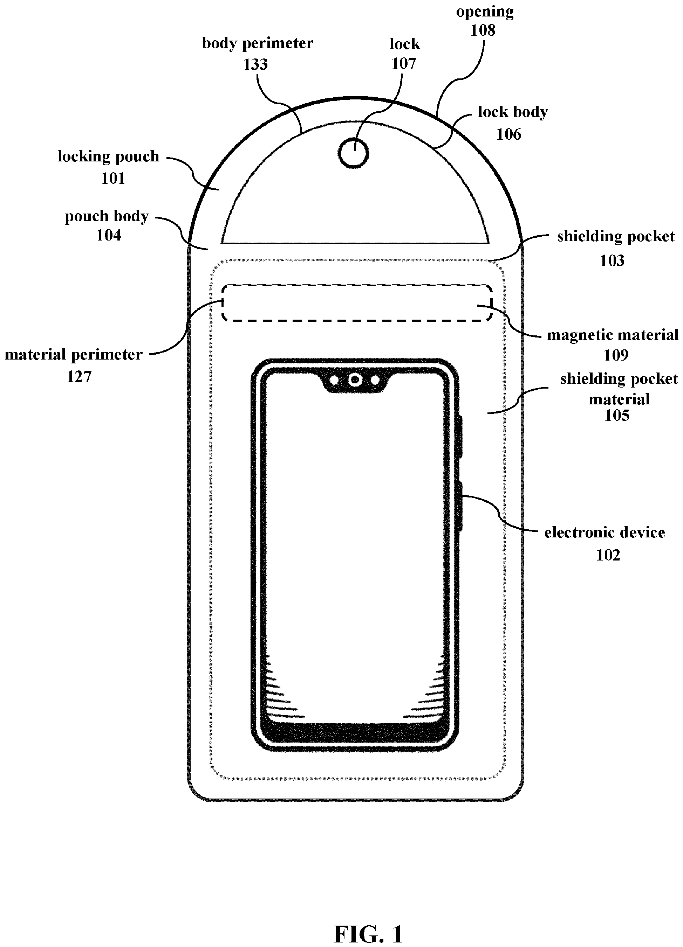

Certain embodiments and principles will be discussed in more detail with reference to the figures. According to some embodiments, FIG. 1 illustrates a container in the form of a locking pouch 101 configured to store an electronic device 102 while preventing the transmission and reception of electromagnetic signals to and/or from the electronic device. To accomplish the signal blocking, the locking pouch 101 includes a shielding pocket 103 positioned within the pouch body 104, which is configured to form an electrically conductive enclosure (e.g., Faraday cage) around the electronic device 102. In some embodiments, the shielding pocket 103 is constructed from one or more shielding material 105 configured to attenuate electromagnetic signals, which may include metalized fabrics, nickel-copper coated fabrics, conductive nylon or polyester, silver-plated fabric, conductive thread, metal-backed polyester mesh, stretchable Faraday fabrics, aluminum foil fabric, and/or heat-sealed metalized films, as non-limiting examples. The pouch body 104 further comprises a lock body 106 on either side, where each lock body is secured to each other using a lock 107 to prevent unauthorized access.

In some embodiments, the lock 107 is configured to secure an opening 108 at the pouch body upper portion, providing an entry point for inserting the electronic device 102. In some embodiments, this opening introduces a potential pathway for electromagnetic leakage, as the shielding pocket 103 must remain accessible for insertion and removal of the device. To create an electromagnetic seal, in some embodiments, the shielding pocket 103 includes a magnetic material 109 positioned along its edges, depicted as a dotted-line strip in this non-limiting example. The term "magnetic material" can be interpreted as a magnetized material or a material that can be attracted through magnetic force, such as ferromagnetic material. The examples described in relation to the figures have magnetic material on either side of an opening, where at least one side has magnetic material in the form of magnetized material configured to attract the magnetic material on the other side through magnetic force. Therefore, various combinations of the non-limiting examples described herein may be formed using different portions of each of the drawings and associated descriptions, so long at one side of the opening includes magnetized material.

In some embodiments, the magnetic material 109 is positioned on opposing sides of the shielding pocket material 105, and is configured to attract to each other, applying force that brings the shielding pocket material 105 into continuous electrical contact. The magnetic material 109 may include one or more magnets, one or more magnetized strips, one or more magnetic strips and/or ferromagnetic material, depending on the application. In some embodiments, the compressive force of the magnetic material 109 ensures that the shielding pocket 103 remains fully enclosed, thereby completing the Faraday cage electrical circuit and preventing electromagnetic leakage through the opening 108. The combination of magnetic force and material compression enhances the shielding integrity of the pouch, ensuring effective containment of electromagnetic emissions from the enclosed electronic device 102, in accordance with some embodiments.

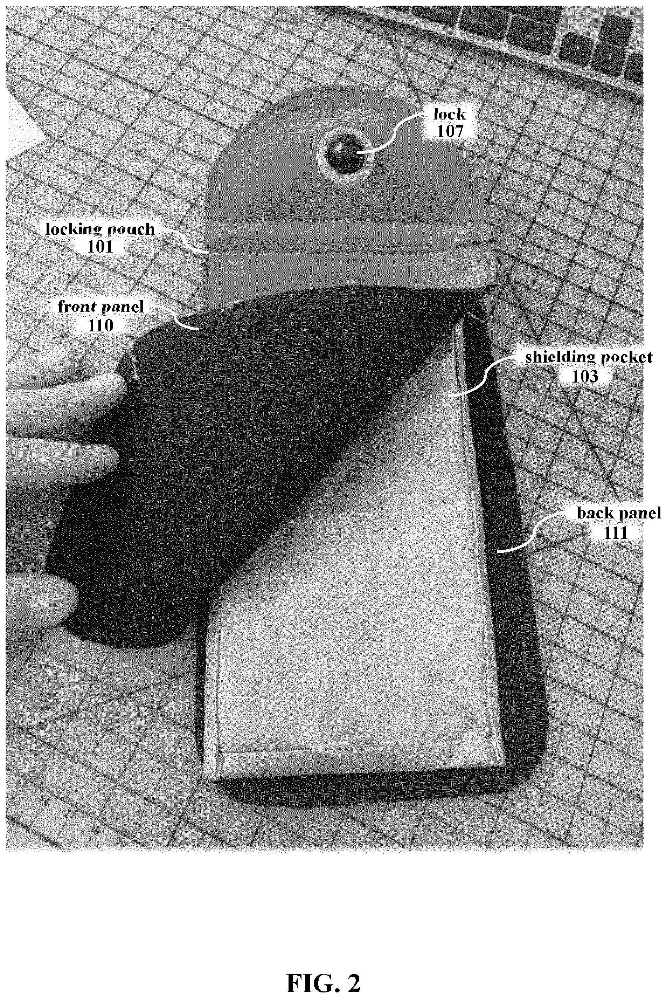

FIG. 2 illustrates the structural components of the locking pouch 101. In some embodiments, the shielding pocket 103 is positioned between a front panel 110 and a back panel 111. The front panel 110 and back panel 111 are coupled together along their edges, which form the pouch body 104 that houses the shielding pocket 103. In some embodiments, the front panel 110 is coupled to the back panel 111 using adhesive, stitching, or other attachment methods, with stitching provided as an example and not as a limitation. In some embodiments, at least a portion of the shielding pocket 103 is positioned independently within the locking pouch 101 such that it is not directly coupled to the front panel or back panel through perforations, preventing any compromise in the electromagnetic shielding properties of the shielding material 105.

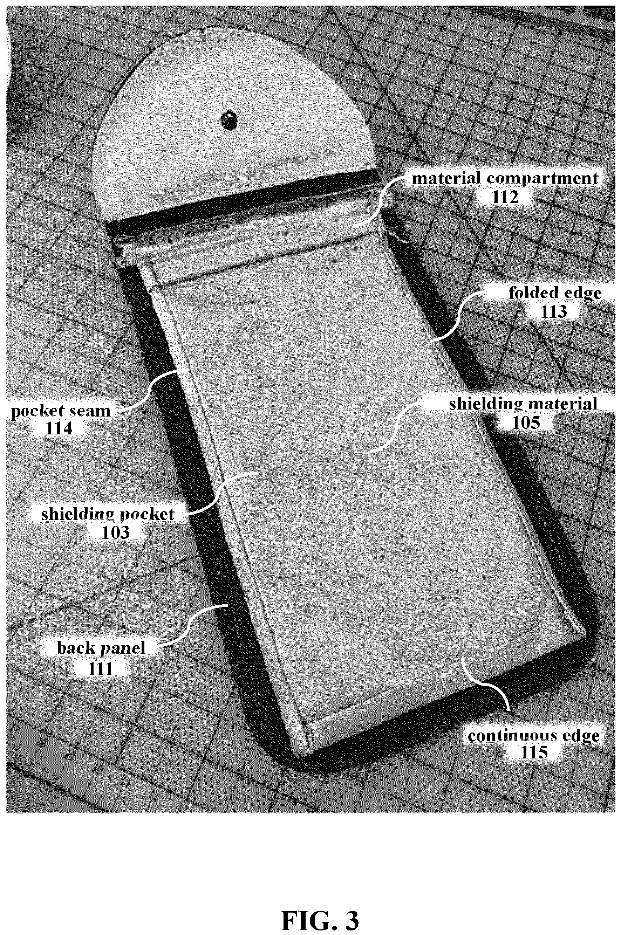

FIG. 3 illustrates the shielding pocket 103 with the front panel 110 removed, in accordance with some embodiments. In some embodiments, the shielding pocket 103 includes a material compartment 112 located at its upper portion near the opening 108. The material compartment 112 is configured to house magnetic material 109, which may include a magnetic strip, ferromagnetic material, or discrete magnets, a non-limiting examples. In some embodiments, the material compartment 112 is formed by wrapping the shielding material 105 around the magnetic material 109, securing the magnetic material 109 within the compartment. In some embodiments, the magnetic material 109 is coupled to the surface of the shielding material 105 using adhesive, fasteners, and/or other fastening techniques. In some embodiments, the shielding material includes at least one folded edge 113 configured to prevent a direct path for electronic signals. In some embodiments, the shielding material 105 includes a continuous edge 115, where the continuous edge 115 may also be folded, in accordance with some embodiments.

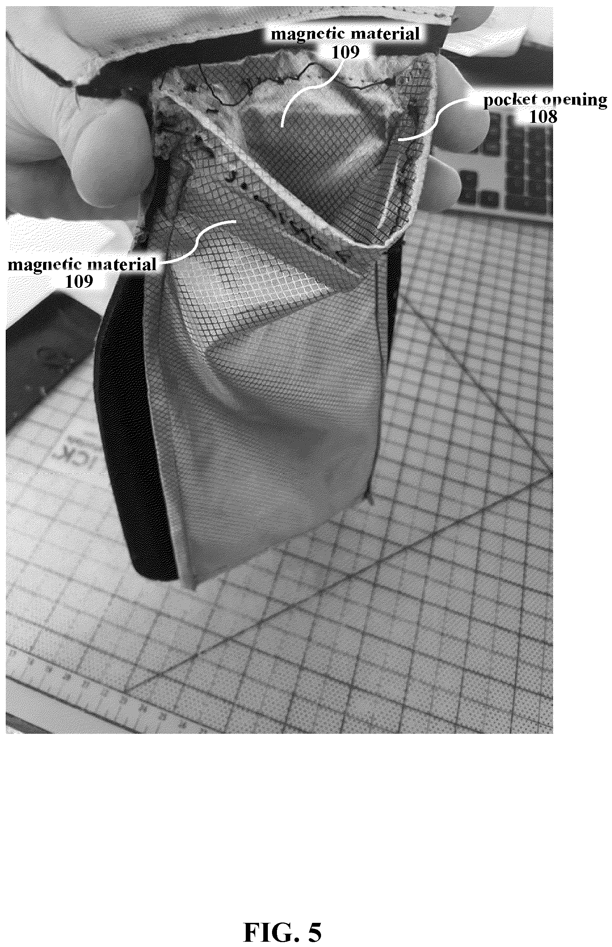

In some embodiments, the shielding pocket 103 is formed from tube or sleeve of electrically conductive material, where the tube or sleeve includes at least one opening for the electronic device 102, best shown in FIG. 5. Turning back to FIG. 3, in some embodiments, the shielding pocket 103 material forms a continuous electrically conductive surface with the exception of the at least one pocket opening 108. In some embodiments, the shielding pocket 103 is formed by folding the shielding material 105 into two halves, where the bottom half forms a continuous edge 115. In some embodiments, the sides of the shielding pocket 103 are coupled using a pocket coupling, such as adhesive, stitching, and/or conductive materials, forming a pocket seam 114, ensuring that the shielding pocket 103 remains structurally secure. In some embodiments, the adhesive or stitching material may include conductive properties, further enhancing the Faraday cage effect. In some embodiments, the sides of the shielding material 105 are folded over, eliminating a direct pathway for electromagnetic signals to escape.

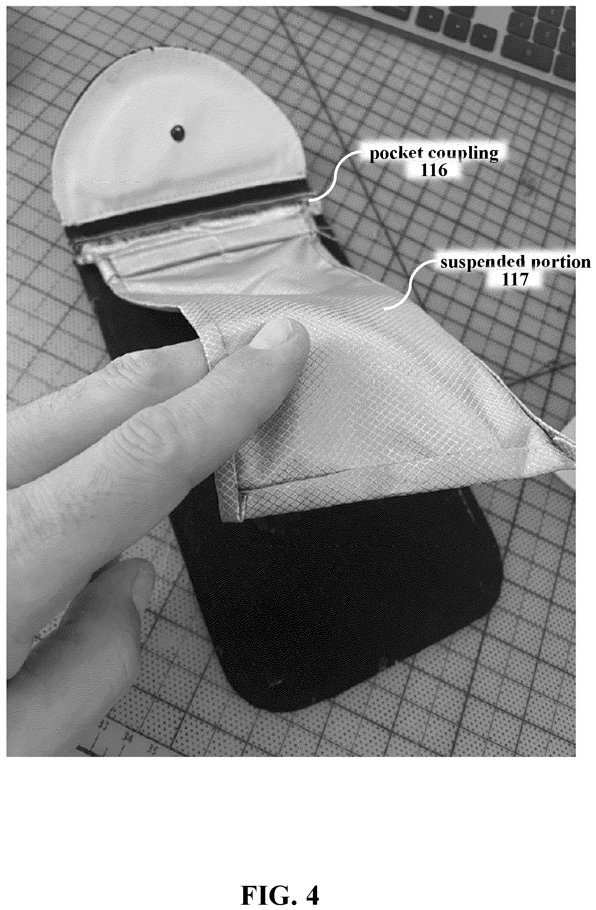

FIG. 4 depicts a non-limiting example of a pocket coupling 116, which couples the shielding pocket 103 to at least one of the front panel 110 and/or back panel 111 of the locking pouch 101. The pocket coupling 116, which includes electrically conductive stitching in this example, is positioned at the upper portion of the pouch, near the lock body 106. Below this coupling, the shielding pocket 103 is not coupled to the pouch body 104, forming a suspended portion 117. This configuration allows the shielding pocket 103 to hang freely within the locking pouch 101, ensuring that it is not restricted or compressed in a way that could compromise electromagnetic shielding properties. The suspended portion 117 maintains flexibility, enabling the shielding pocket 103 to fully surround an electronic device 102 while allowing for movement within the pouch.

FIG. 5 illustrates the pocket opening 108 of the shielding pocket 103 which provides an entry point for inserting or removing an electronic device 102. As discussed *supra,* the pocket opening 108 is configured to be held closed by magnetic forces, generated by magnetic material 109 positioned on opposing sides of the shielding pocket 103. The magnetic material 109 on a first side is configured to attract to magnet material on a second side of the shielding pocket 103, ensuring that the shielding pocket 103 remains sealed when in a closed state. In some embodiments, the magnetic force securing the pocket opening 108 can be overcome by hand force, allowing a user to manually separate the magnetic material 109 by applying pressure, such as by squeezing the opening 108.

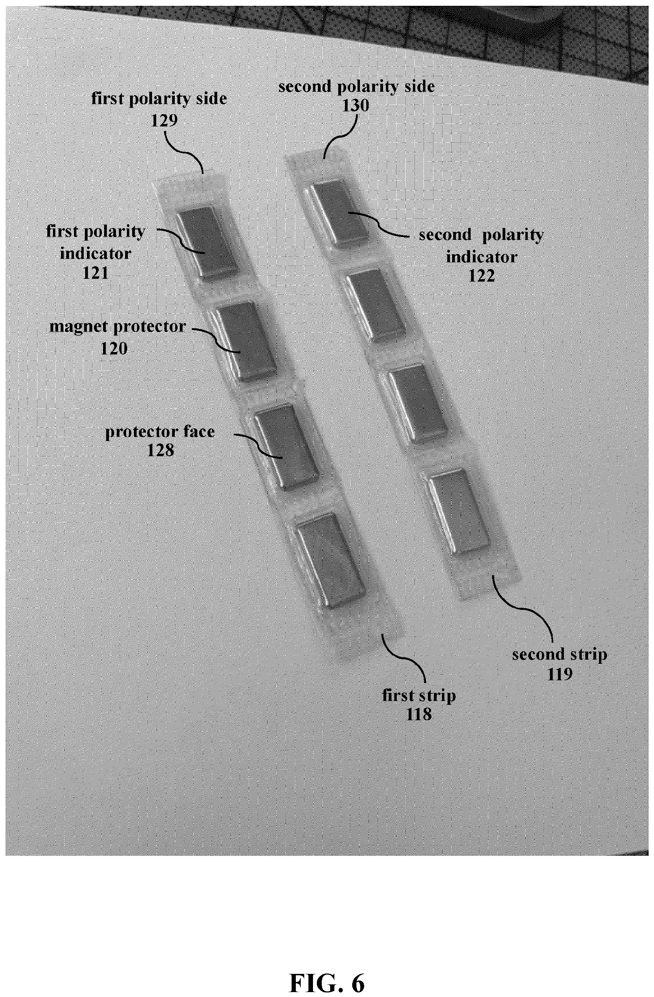

FIG. 6 illustrates a first strip 118 of magnetic material and a second strip 119 of magnetic material, in accordance with some embodiments. In some embodiments, each strip is configured to house magnetic material 109 that enables the sealing of the shielding pocket 103. In some embodiments, the magnetic material 109 within each strip is covered by a magnet protector 120, which may be composed of a ferromagnetic material, such as steel in this non-limiting example. In some embodiments, each magnet protector 120 includes a polarity indicator to ensure proper orientation within the material compartment 112 during assembly. The first polarity indicator 121 corresponds to a first polarity, while the second polarity indicator 122 corresponds to a second polarity, opposite to the first. The first polarity is configured to attract the second polarity, ensuring that the magnets are properly aligned when inserted into the material compartment 112 of the shielding pocket 103. This alignment feature prevents misplacement during assembly and ensures optimal magnetic attraction, contributing to the effective sealing of the shielding pocket 103.

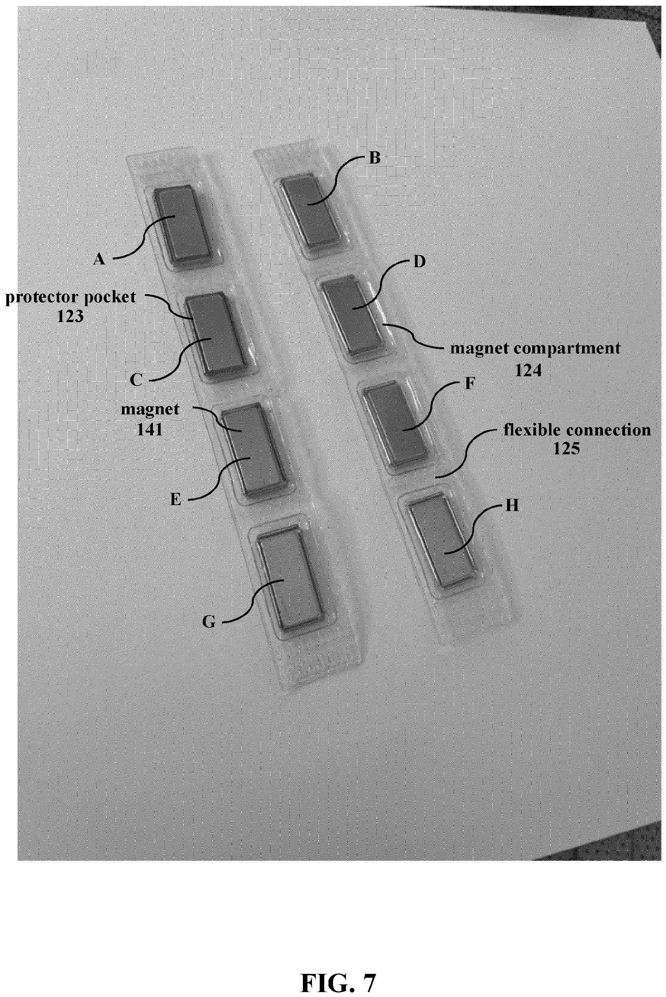

FIG. 7 illustrates the magnetic arrangement within the first strip 118 and second strip 119, showing how individual magnets (A, B, C, D, E, F, G, H) are positioned within a protector pocket 123 of a magnet protector 120, as well as how each magnet/protector is housed within a magnet compartment 124 of a respective strip, which prevents unintended attraction between magnets within the same strip. In some embodiments, the magnet compartments 124 are configured to ensure proper alignment between corresponding magnets on the first strip 118 and second strip 119, allowing for maximum compression of the shielding material 105 when the strips are coupled together.

Between each magnet compartment 124, a flexible connection 125 is present, enabling controlled movement of the magnetic strips while maintaining alignment. In some embodiments, the flexible connection 125 is composed of flexible plastic formed from the same material as the strip. In some embodiments, the flexible connection 125 may be constructed from other flexible materials, depending on requirements for strength and/or flexibility.

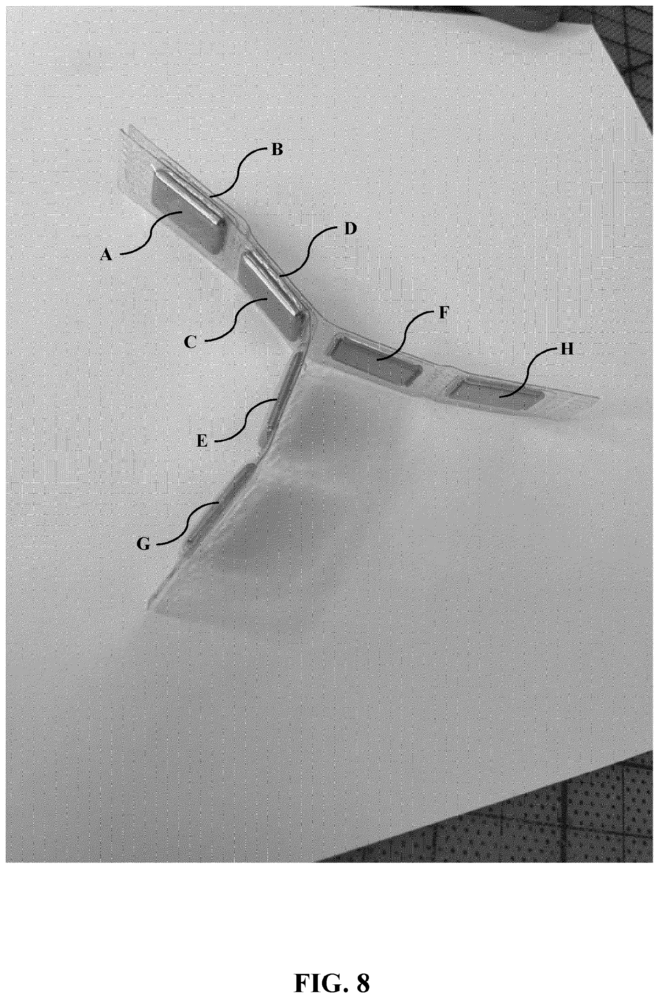

FIG. 8 shows the flexibility and alignment of the first strip 118 and the second strip 119, in accordance with some embodiments. In some embodiments, magnet A aligns with magnet B, magnet C aligns with magnet D, magnet E aligns with magnet F, and magnet G aligns with magnet H. Although only four magnets are depicted in each strip, any number of magnets may be used to obtain the proper compressive and/or flexibility requirements. Indeed, such magnets can vary in the number of magnets (e.g., 1 to n magnets), as can their shape, size and/or configuration within such strips, without departing from the scope of the instant disclosure. The magnet compartments 124 ensure that each discrete magnet 141 is correctly positioned, preventing unintended attraction along the same strip while enabling proper engagement with the opposing strip. The flexible connections 125 allow for controlled movement while maintaining proper alignment between the first strip 118 and second strip 119, ensuring that when the magnets are coupled, they compress the shielding material 105 effectively, maintaining the Faraday cage effect and preventing electromagnetic leakage when the locking pouch 101 is closed.

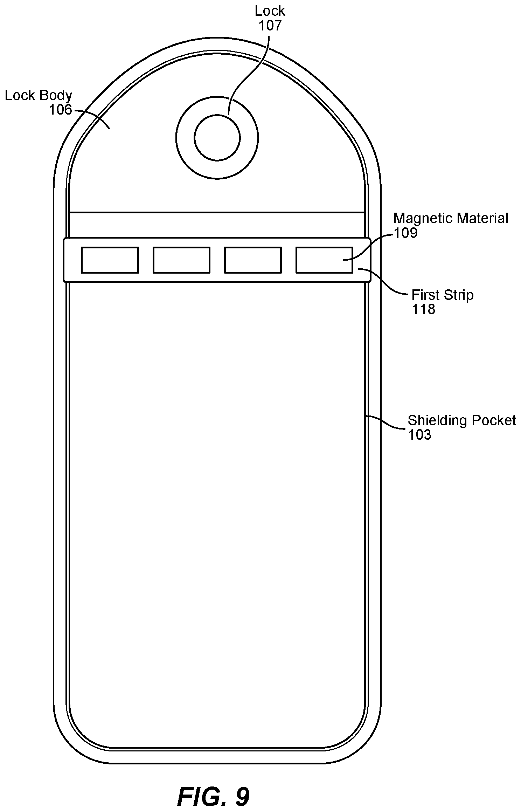

FIG. 9 illustrates example dimensions for the strip and the magnetic materials housed within the strip, in accordance with some embodiments. While specific numbers are used in FIG. 9 in millimeters, these numbers are non-limiting, and example dimensions may be increased or decrease by, for example, 20% or more, so long as the structure provides sufficient force to close and/or secure the opening 108 in a closed position. For example, the width 120.00 mm may be adjusted to be between 90 and 150 mm, depending on the application. The distance 6.00 mm between magnetic material 109 on the first strip 118 may be between 1 and 10 mm, in accordance with some embodiments. Similarly, the gap between the magnetic material 109 and an edge of the shielding pocket 103 may be between 1 and 15 mm, which includes the 7.00 mm example dimension shown. A distance between the magnetic material 109 and a bottom of the first strip 118, currently shown as 3.50 mm may be between 1 and 10 mm. While the length and width of the magnetic material 109 is shown as 10.00 mm and 22.00 mm, respectively, respective dimensions may be between 5-15 mm and 10-35 mm for the length and width. Thus, the dimension, and the shape in general, of the magnetic material 109 and/or the medium in which it is secured may take on any shape, so long as the shape is sufficient to prevent electronic signals from escaping the opening 108.

In the non-limiting example shown in FIG. 9, the strip includes four individual magnetic materials positioned within designated magnet compartments 124. The magnetic materials may be configured as magnets, ferromagnetic material, or a combination of both, depending on the embodiment, as discussed supra. The configuration shown in FIG. 9 enables effective compression of the shielding material 105 when coupled with an opposing strip, ensuring the Faraday cage effect is maintained. The dimensions shown in FIG. 9 are provided as an example and are not limiting, as variations in size, shape, and material composition may be used depending on design and functional requirements.

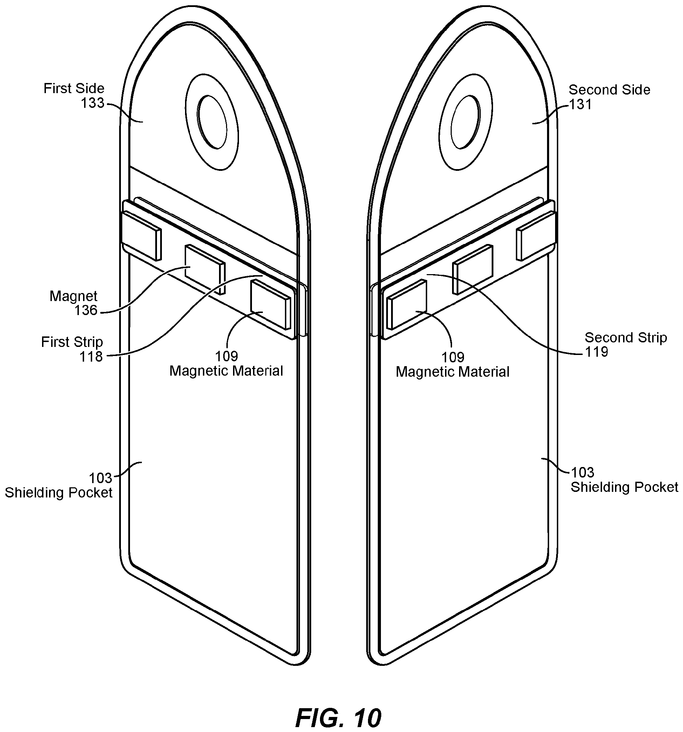

FIG. 10 illustrates a first side 133 and a second side 131 of the locking pouch 101, where each side comprises a strip comprising three sets of magnetic material 109. In some embodiments, the magnetic materials are stored within designated magnet compartments 124. While similar to the configuration shown in FIG. 9, which includes four discrete magnetic materials per strip, the embodiment in FIG. 10 utilizes a set of three discrete magnetic materials on each strip. In some embodiments, the number of magnetic materials may be adjusted depending on design and functional requirements while maintaining the Faraday cage effect. For example, the first strip 118 and/or second strip 119 may include a ferromagnetic material, where the magnetic material is configured to impart magnetic properties to the ferromagnetic material to create a more even distribution of magnetic force, while minimizing the number of magnets needed for strength and flexibility, as well as cost.

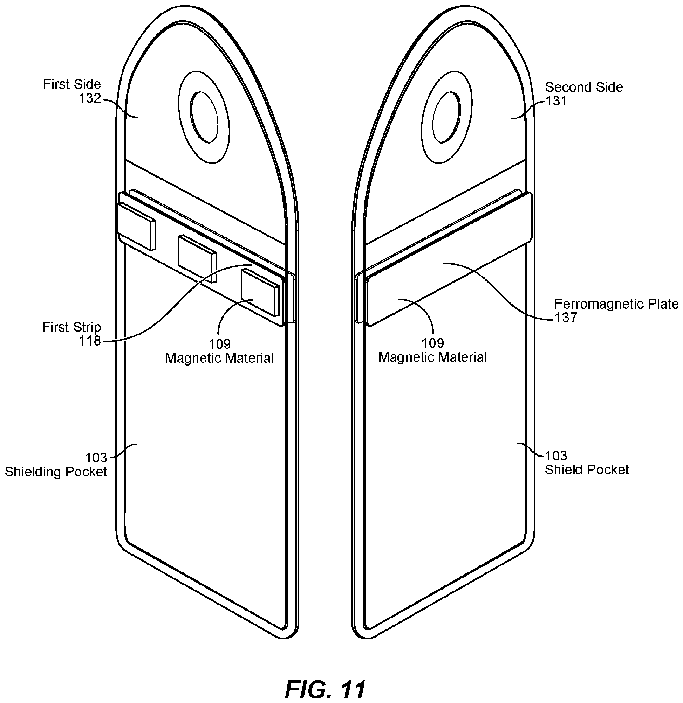

FIG. 11 illustrates a first side 133 comprising a first strip 118 with three sets of magnetic material 109 and a second side 131 incorporating a ferromagnetic plate 137. The magnetic material 109 housed within the first strip 118 is configured to generate an attractive force with the ferromagnetic plate 137 positioned on the second side 131. In some embodiments, the first strip also includes a ferromagnetic plate, as discussed above. The ferromagnetic plate 137 is configured to enhance the attraction force by providing a larger conductive surface area that helps distribute pressure across the shielding material 105. This configuration allows for secure compression of the shielding pocket 103 without requiring both sides to have magnetized material. In some embodiments, the ferromagnetic plate 137 further contributes to the Faraday cage effect by ensuring that the electromagnetic shielding properties of the shielding pocket 103 remain intact when the magnetic strip and ferromagnetic plate 137 are coupled together.

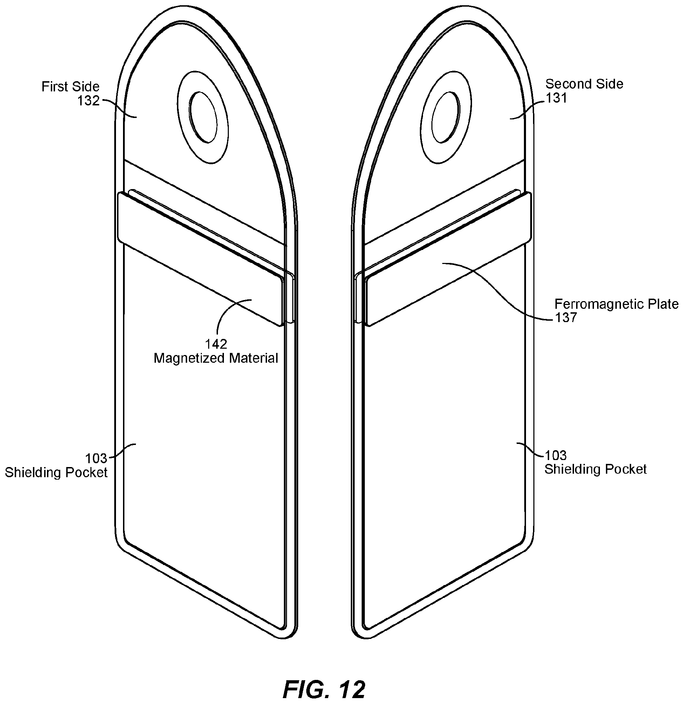

FIG. 12 illustrates a first side 133 comprising a magnetized material 142 and a second side 131 incorporating magnetic material in the form of a ferromagnetic plate 137. The ferromagnetic plate 137 provides a broader conductive surface, which enhances electromagnetic shielding while ensuring a consistent and even closure of the shielding pocket 103. By distributing the contact pressure over a larger area, the ferromagnetic plate 137 improves the sealing effect of the Faraday cage. In some embodiments, both sides may utilize magnetized strips, rather than a magnetized strip and a ferromagnetic plate, depending on design requirements and the desired sealing force for the shielding pocket 103.

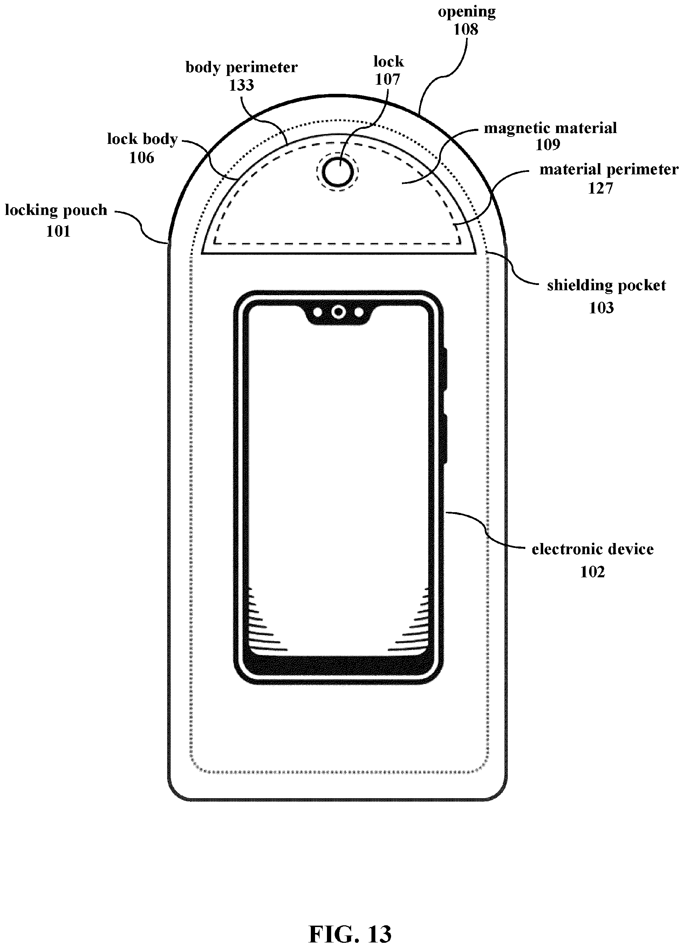

FIG. 13 illustrates a locking pouch 101 similar to the configuration shown in FIG. 1, with the distinction that the shielding pocket 103 extends above the top portion of the locking pouch 101. In some embodiments, each lock body 106 on either side of the opening 108 includes magnetic material 109, where at least one lock body includes magnetized material, which enhances the sealing force applied to the shielding pocket 103. In some embodiments, the material perimeter 127 of the magnetic material 109 extends substantially around the body perimeter 133 of the lock body 106, where the opposite side of the locking pouch 101 includes a corresponding lock body 106 with magnetic material 109 (e.g., magnetized material) and/or a similar material perimeter 127. When the lock bodies are forced together by the magnetic force and secured by the lock 107, pressure is applied to the shielding pocket 103, completing the electrical circuit for the conductive material, ensuring that the Faraday cage effect is maintained by fully sealing the shielding pocket 103 from electromagnetic signals.

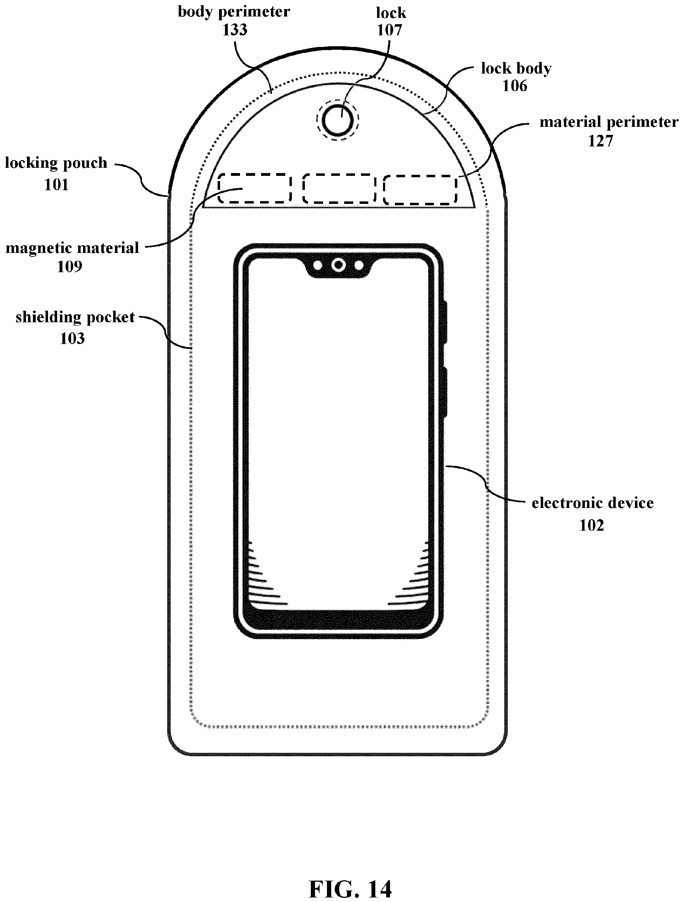

FIG. 14 illustrates a locking pouch 101 similar to the configuration shown in FIG. 13, with the distinction that the magnetic material 109 is distributed as three individual magnets embedded within the lock body 106. However, it is understood that the number of magnets and/or discrete magnetic material is not limiting, and that three magnets is only used as an illustration of an example configuration in accordance with some embodiments. Indeed, as discussed herein, the number of magnets within material 109 can vary from 1 to n magnets, as can each magnet's shape and/or size, without departing from the scope of the instant disclosure. The shielding pocket 103 extends above the top portion of the locking pouch 101, ensuring a secure enclosure for the electronic device 102. The other locking body on the opposite side may have any combination of magnetic material and/or material shapes described herein. In some embodiments, the magnetic material 109 shown in the front lock body 106 includes four discrete magnets positioned within and/or coupled to the lock body 106, allowing for localized magnetic attraction to corresponding magnetic material 109 on the opposite side of the locking pouch 101. The opposite lock body 106 may include four magnets, ferromagnetic material, or a combination of both, depending on the embodiment. In some embodiments, the opposing magnetic material may not be coupled to the opposing lock body, and instead be coupled to the back panel 111, shielding pocket 103, or some other structured. In this example, however, the lock bodies are configured to be forced together by magnetic attraction, while the lock 107 further secures the closure. Some embodiments may incorporate different combinations of magnets and ferromagnetic materials to achieve the desired sealing force and electromagnetic shielding properties.

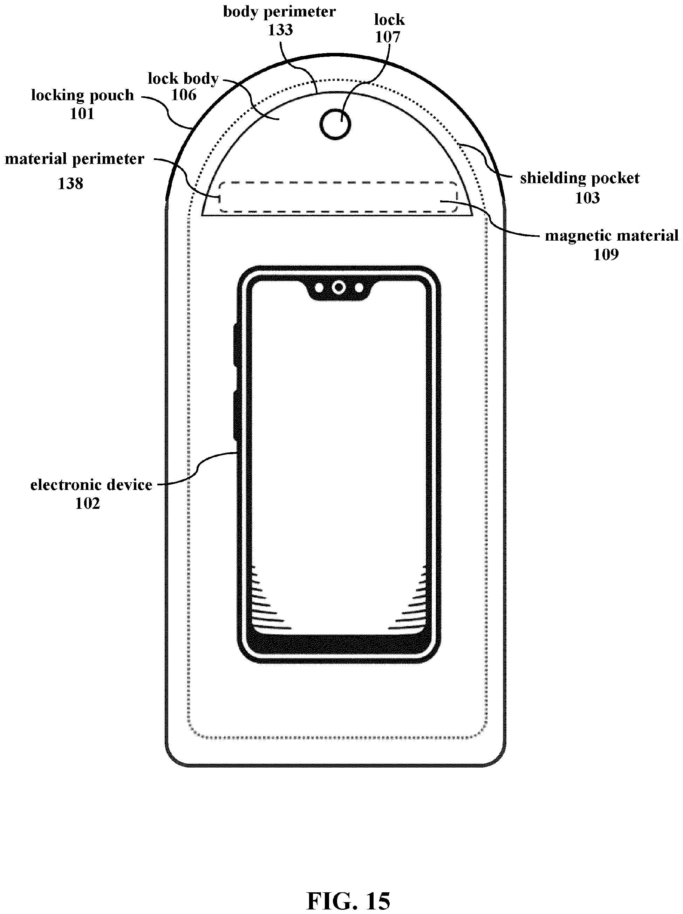

FIG. 15 illustrates a locking pouch 101 similar to the configuration shown in FIG. 14, with the distinction that the magnetic material 109 includes an elongated strip of magnetic material 109 instead of discrete magnets, in accordance with some embodiments. As in FIGs. 13 and 14, the shielding pocket 103 extends above the top portion of the locking pouch 101 to ensure secure electromagnetic shielding. In some embodiments, the elongated strip of magnetic material 109 is configured to provide continuous compression along the length of the shielding pocket 103. The magnetic strip aligns with corresponding magnetic material 109 on the opposite lock body 106, which can take any form described herein, creating a uniform sealing force across the shielding pocket 103.

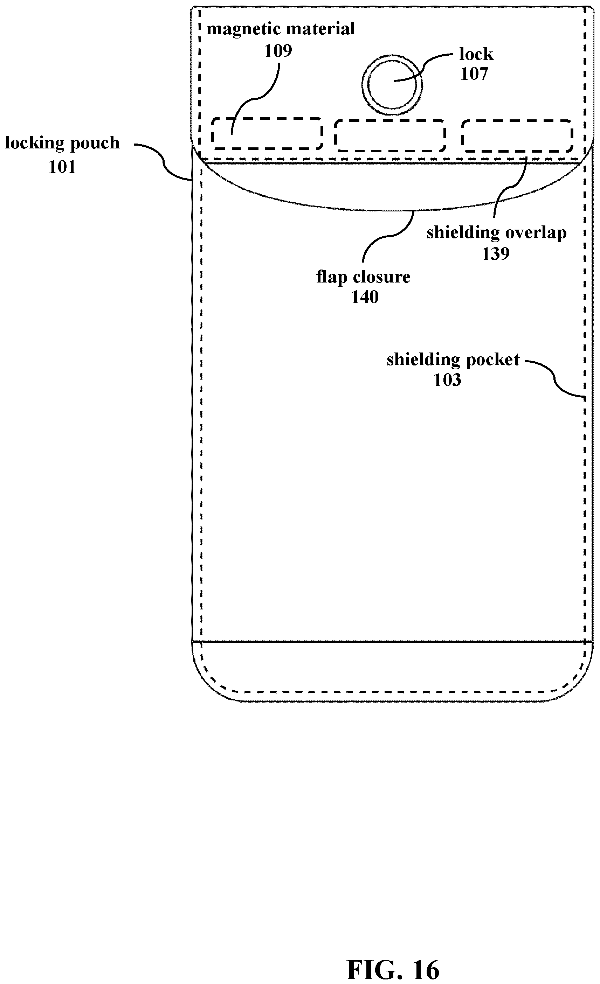

FIG. 16 illustrates a locking pouch 101 similar to the configuration shown in FIG. 15, with the distinction that the top portion of the shielding pocket 103 includes an extension of the shielding material 105 that is folded over. As above, while only three magnets are illustrated, any number of magnets and/or discrete magnetic material may be used, as understood via the instant disclosure and accompanying drawings. This folded portion is configured to prevent a direct path for electromagnetic signals to escape, further enhancing the Faraday cage effect, in accordance with some embodiments. In some embodiments, the folded-over shielding material 105 provides an additional barrier that disrupts any potential leakage path through the opening 108 of the shielding pocket 103. In some embodiments, the magnetic material 109 is positioned within the material configured to be folded and is configured to apply compression force to the shielding material 105 through attraction to magnetic material located on the front (or rear) panel. Any magnetic material described herein can take any form, so long as the proper compression force is applied.

In some embodiments, electrically conductive plating is applied to one or more components of the locking pouch 101 to enhance electromagnetic shielding, durability, and/or corrosion resistance. In some embodiments, the magnetic material 109, which may include magnetic strips, discrete magnets, and/or ferromagnetic plates, as discussed *supra,* may include conductive plating to improve conductivity and ensure a more continuous Faraday cage effect by maintaining electrical connectivity across the shielding pocket 103. The conductive plating further enhances corrosion resistance, preventing oxidation or degradation of magnetic or ferromagnetic components over time, while also ensuring a uniform surface to facilitate consistent magnetic attraction between opposing components.

In some embodiments, the shielding pocket 103 may include conductive plating at contact areas, for example, where the shielding material meets the magnetic sealing components. This application, in accordance with some embodiments, ensures consistent conductivity, reducing the potential for signal leakage at connection points, while also improving the wear resistance of the shielding pocket 103 under repeated mechanical compression. In some embodiments, the lock bodies 106 may also include conductive plating to improve durability and prevent oxidation, ensuring the locking mechanism maintains functionality under repeated use. In some embodiments, conductive plating is used if the a lock body 106 includes embedded magnetic material or ferromagnetic elements.

In some embodiments, conductive plating is applied to seams or coupling points of the shielding pocket 103, particularly in areas where the shielding material is adhered, stitched, or pressed together. This configuration enhances electrical contact across the shielding pocket 103, minimizing potential gaps that could result in electromagnetic leakage. In embodiments where a ferromagnetic plate 137 is used on one side instead of a second magnetized strip, conductive plating on the ferromagnetic material is configured to enhance surface conductivity, providing a smooth, uniform surface to optimize magnetic attraction while also improving corrosion resistance of the ferromagnetic material 137.

The conductive plating, in accordance with some embodiments, may be composed of one or more materials, including silver, gold, copper, zinc-nickel alloy, tin, and/or palladium, depending on the desired electrical conductivity, shielding performance, and corrosion resistance. Silver plating provides the highest electrical conductivity, optimizing electromagnetic shielding, while gold plating offers exceptional corrosion resistance and long-term durability. Copper plating enhances electromagnetic performance and, in some embodiments, may serve as an underlayer for other plating materials. Zinc-nickel alloy plating increases corrosion resistance, making it suitable for environments where moisture or oxidation is a concern. Tin plating provides a cost-effective balance of conductivity and oxidation resistance, while palladium plating offers strong wear resistance and moderate conductivity. The selection of plating material is dependent on performance requirements, environmental exposure, and cost considerations within the locking pouch system.

It should be understood that the disclosed system is not limited in its application to the details of construction and the arrangement of components set forth in the previous description or illustrated in the drawings. The systems and methods disclosed herein fall within the scope of numerous embodiments. The previous discussion is presented to enable a person skilled in the art to make and use the system according to some embodiments. Any portion of the structures and/or principles included in some embodiments can be applied to any and/or all embodiments, and it should be understood that features from some embodiments presented herein are combinable with other features according to some other embodiments. Thus, some embodiments of the system are not intended to be limited to what is illustrated but are to be accorded the widest scope consistent with all principles and features disclosed herein.

For example, the system can be described as a container comprising one or more of a container body, a shielding pocket, a lock, a first magnetic material, and a second magnetic material. In some embodiments, the shielding pocket in positioned within the container body. In some embodiments, the shielding pocket is configured to block electromagnetic signals. In some embodiments, the shielding pocket includes an opening configured to enable an electronic device to be inserted into an interior of the shielding pocket. In some embodiments, the first magnetic material is positioned on a first side of the opening and the second magnetic material is positioned on a second side of the opening. In some embodiments, the first magnetic material and the second magnetic material are configured to close the opening through magnetic force.

In some embodiments, the lock is configured to prevent access to the shielding pocket. In some embodiments, the magnetic force is sufficient to close the opening such that the shielding pocket substantially prevents a transmission and/or a reception of the electromagnetic signals. In some embodiments, the magnetic force is sufficient to enable the shielding pocket to form a Faraday cage around the electronic device. In some embodiments, the magnetic force is sufficient to enable shielding pocket material on a first side the shielding pocket to form electrical contact with shielding pocket material on a second side of the shielding pocket. In some embodiments, the electrical contact is sufficient to enable the shielding pocket to form a Faraday cage around the electronic device.

In some embodiments, the lock includes a first lock body and a second lock body. In some embodiments, the shielding pocket is located beneath the first lock body and the second lock body. In some embodiments, the first magnetic material is coupled to the first side of the shielding pocket. In some embodiments, the second magnetic material is coupled to the second side of the shielding pocket. In some embodiments, the first magnetic material includes a first strip. In some embodiments, the first strip includes two or more discrete magnets. In some embodiments, the two or more discrete magnets are each stored within magnetic compartments formed in the first strip. In some embodiments, the magnetic compartments are coupled to each other by a respective flexible connection. In some embodiments, the respective flexible connection is configured to enable the opening to open.

In some embodiments, the second magnetic material includes a second strip. In some embodiments, the first strip comprises a first magnetized material. In some embodiments, the second strip comprises a second magnetized material. In some embodiments, the lock includes a first lock body and a second lock body. In some embodiments, the first lock body is in contact with shielding pocket material. In some embodiments, the second lock body is in contact with shielding pocket material. In some embodiments, the first lock body includes the first magnetic material. In some embodiments, the second lock body includes the second magnetic material.

As illustrated by the various features of the system in accordance with some embodiments, numerous features may be barrowed from various examples while still remaining within the scope of the disclosure.

Some embodiments of the system are presented with specific values and/or setpoints. These values and setpoints are not intended to be limiting and are merely examples of a higher configuration versus a lower configuration and are intended as an aid for those of ordinary skill to make and use the system.

Any text in the drawings should be viewed as part of the instant disclosure and should be understood to be readily incorporable into any description of the metes and bounds of the system. Any functional language in the drawings is a reference to the system being configured to perform the recited function, and structures shown or described in the drawings are to be considered as the system comprising the structures recited therein.

Furthermore, acting as Applicant's own lexicographer, Applicant imparts the explicit meaning and/or disavow of claim scope to the following terms: "Substantially" and "approximately" when used in conjunction with a value encompass a difference of 5% or less of the same unit and/or scale of that being measured (e.g., degrees, volume, mass, distance).

It should be understood that the phraseology and terminology used herein is for description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

While various embodiments have been described for purposes of this disclosure, such embodiments should not be deemed to limit the teaching of this disclosure to those embodiments. Various changes and modifications may be made to the elements and operations described above to obtain a result that remains within the scope of the systems and processes described in this disclosure.

## Claims

1. A container comprising:
a container body,
a shielding pocket,
a lock,
a first magnetic material, and
a second magnetic material;
wherein the shielding pocket in positioned within the container body;
where the shielding pocket is configured to block electromagnetic signals;
wherein the shielding pocket includes an opening configured to enable an electronic device to be inserted into an interior of the shielding pocket;
wherein the first magnetic material is positioned on a first side of the opening and the second magnetic material is positioned on a second side of the opening; and
wherein the first magnetic material and the second magnetic material are configured to close the opening through magnetic force.

2. The container of claim 1, wherein the lock is configured to prevent access to the shielding pocket.

3. The container of claim 1 or claim 2, wherein the magnetic force is sufficient to close the opening such that the shielding pocket substantially prevents a transmission and/or a reception of the electromagnetic signals.

4. The container of claim 3, wherein the lock includes a first lock body and a second lock body; and wherein the shielding pocket is located beneath the first lock body and the second lock body.

5. The container of claim 3, wherein the lock includes a first lock body and a second lock body; and wherein the first lock body is in contact with shielding pocket material, and optionally wherein the second lock body is in contact with shielding pocket material.

6. The container of claim 5, wherein the first lock body includes the first magnetic material; and wherein the second lock body includes the second magnetic material.

7. The container of claim 1 or claim 2, wherein the magnetic force is sufficient to enable the shielding pocket to form a Faraday cage around the electronic device.

8. The container of claim 1 or claim 2, wherein the magnetic force is sufficient to enable shielding pocket material on a first side the shielding pocket to form electrical contact with shielding pocket material on a second side of the shielding pocket.

9. The container of claim 8, wherein the electrical contact is sufficient to enable the shielding pocket to form a Faraday cage around the electronic device.

10. The container of claim 8, wherein the first magnetic material is coupled to the first side of the shielding pocket, and optionally wherein the second magnetic material is coupled to the second side of the shielding pocket.

11. The container of claim 10, wherein the first magnetic material includes a first strip.

12. The container of claim 11, wherein the first strip includes two or more discrete magnets, and optionally wherein the two or more discrete magnets are each stored within magnetic compartments formed in the first strip.

13. The container of claim 11, wherein the magnetic compartments are coupled to each other by a respective flexible connection, and optionally wherein the respective flexible connection is configured to enable the opening to open.

14. The container of any of claims 11-13, wherein the second magnetic material includes a second strip.

15. The container of claim 14, wherein the first strip comprises a first magnetized material, and optionally wherein the second strip comprises a second magnetized material.
